(19) Europäisches Patentamt
European Patent Office
Office européen des brevets

(11) EP 0 620 572 B1

(12) **EUROPEAN PATENT SPECIFICATION**

(45) Date of publication and mention
of the grant of the patent:
**15.07.1998 Bulletin 1998/29**

(51) Int Cl.6: **G01R 33/06**, G11B 5/39,
H01F 10/08

(21) Application number: **94105649.1**

(22) Date of filing: **13.04.1994**

(54) **Element having magnetoresistive effect**

Element mit magnetoresistivem Effekt

Elément à effet magnétorésistif

(84) Designated Contracting States:
**DE FR GB NL**

(30) Priority: **13.04.1993 JP 85947/93**
**09.07.1993 JP 170081/93**
**10.06.1993 JP 138198/93**

(43) Date of publication of application:
**19.10.1994 Bulletin 1994/42**

(73) Proprietor: **MATSUSHITA ELECTRIC INDUSTRIAL**
**CO., LTD.**
**Kadoma-shi, Osaka-fu, 571 (JP)**

(72) Inventors:
• **Sakakima, Hiroshi**
**Tsuzuki-gun, Kyoto-fu (JP)**
• **Satomi, Mitsuo**
**Katano-shi, Osaka-fu (JP)**
• **Irie, Yousuke**
**Kadoma-shi, Osaka-fu (JP)**

(74) Representative: **Eisenführ, Speiser & Partner**
**Martinistrasse 24**
**28195 Bremen (DE)**

(56) References cited:
• **JOURNAL OF MAGNETISM AND MAGNETIC**
**MATERIALS, vol.121, no.3, March 1993,**
**AMSTERDAM NL pages 386 - 389 J.P.NOZIERES**
**ET AL**
• **PHYSICAL REVIEW, B. CONDENSED MATTER,**
**vol.43, no.1, 1 January 1991, NEW YORK US**
**pages 1297 - 1300 B.DIENY ET AL**
• **JOURNAL OF MAGNETISM AND MAGNETIC**
**MATERIALS, vol.121, no.3, March 1993,**
**AMSTERDAM NL pages 429 - 431**
**S.TSUNASHIMA ET AL**
• **JOURNAL OF THE PHYSICAL SOCIETY OF**
**JAPAN, vol.59, no.9, September 1990, TOKYO JP**
**pages 3061 - 3064 T.SHINJO ET AL**

**Description**

The invention relates to an element having magnetoresistive effect comprising a first magnetic thin layer, a nonmagnetic metallic thin layer deposited on said first magnetic thin layer, a second magnetic thin layer deposited on said nonmagnetic metallic thin layer, and an antiferromagnetic layer deposited on said second magnetic thin layer.

Such a structure is known from Journal of Magnetism and Magnetic Materials 93, p101, 1991, and Journal of Magnetism and Magnetic Materials 121, (1993) March II, No. 3, pages 386-389.

The present invention particularly relates to an element which can be employed in a magnetoresistance sensor, a magnetoresistance head or the like.

In developing magnetoresistance sensors (hereinafter referred to as MR sensors) or magnetoresistance heads (hereinafter referred to as MR heads) employing a magnetoresistive element, permalloys of $Ni_{0.8}Fe_{0.2}$ or alloy films of $Ni_{0.8}Co_{0.2}$ have been primarily used for magnetic materials. These materials having magnetoresistive effect generally exhibit a ratio of change of magnetoresistivity (hereinafter referred to as MR ratio) of about 2.5%. There is an increasing demand for the development of materials having a large MR ratio in order to obtain a high-sensitivity magnetoresistive element. It was discovered and disclosed several years ago in "Physical Review Letters (Vol. 61, p2472, 1988)" and "Physical Review Letters (Vol. 64, p2304, 1990)" that a giant magnetoresistive effect was provided by an Fe/Cr or Co/Ru artificial superlattice structure in which an antiferromagnetic coupling exists between adjacent Fe or Co layers across a nonmagnetic metallic thin layer made of Cr or Ru, respectively.

Also, it was discovered and disclosed in "Journal of The Physical Society of Japan (Vol. 59, p3061, 1990)" that a giant magnetoresistive effect was provided as well by an artificial superlattice structure of Ni-Fe/Cu/Co in which a magnetic metallic thin layer made of Ni-Fe and a magnetic metallic thin layer made of Co are separated by a nonmagnetic metallic thin layer made of Cu and are not magnetically coupled with each other. The superlattice structure exhibited an MR ratio of approximately 10% by the application of a magnetic field of 3 kOe at room temperature.

In addition, it was also discovered and disclosed in a "Report (MR91-9) of Technical Research" published by Electronic Information Communication Society that a giant magnetoresistive effect was provided by an artificial superlattice structure of Ni-Fe-Co/Cu/Co or Ni-Fe-Co/Cu in which an antiferromagnetic coupling exists between an Ni-Fe-Co thin layer and a Co layer or between adjacent Ni-Fe-Co thin layers across a Cu thin layer, respectively. This superlattice structure exhibited an MR ratio of approximately 15% by the application of a magnetic field of 0.5 kOe at room temperature.

There is also an increasing demand for the development of an artificial metallic superlattice structure operable with a high sensitivity in a lower magnetic field so as to allow it to be used in a magnetic head.

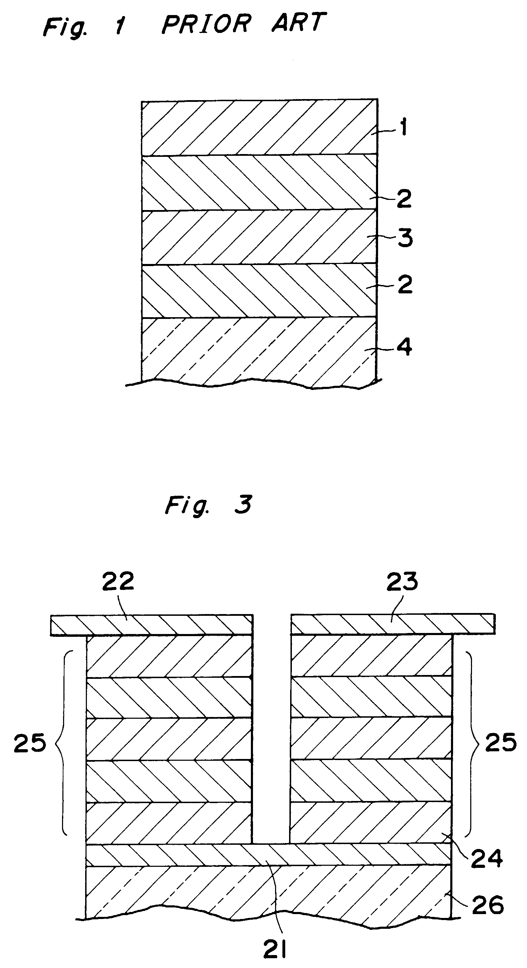

Fig. 1 schematically depicts a spin-valve type artificial superlattice structure comprising Ni-Fe/Cu/Ni-Fe layers 2, 3 and 2 deposited one above the other on a substrate 4 and an Fe-Mn layer 1 deposited on the Ni-Fe/Cu/Ni-Fe layers 2, 3 and 2. This structure was proposed in "Journal of Magnetism and Magnetic Materials (93, p101, 1991)" and is operable in a small magnetic field. The MR ratio of this structure is, however, as low as approximately 2%. As described above, because the artificial superlattice structure of Ni-Fe(-Co)/Cu provides a giant magnetoresistive effect, it is conceivable that an element having a giant magnetoresistive effect can be obtained by depositing the Fe-Mn layer on the Ni-Fe(-Co)/Cu superlattice structure having an MR ratio of 15%. But actually, the MR ratio of the element obtained in such a manner is low of approximately 2%.

The present invention has been developed to overcome the above-described disadvantages.

It is accordingly an objective of the present invention to provide a magnetoresistive element having a large MR ratio which is operable with a high sensitivity in a very small magnetic field.

In accomplishing the above and other objectives, an element according to the present invention comprises a plurality of laminates of said layers deposited one above the other, and a plurality of nonmagnetic metallic layers each having a thickness of 0.5 to 3 nm and being interposed between neighboring laminates to weaken a magnetic coupling between the neighboring laminates, and said first magnetic thin layer having a low magnetostriction and a thickness of 2 to 4 nm, said nonmagnetic metallic thin layer having a thickness of 0.5 to 3 nm, said second magnetic thin layer having a low magnetostriction and a thickness of 2 to 4 nm, and said antiferromagnetic layer having a thickness of 1 to 6 nm.

The number of said laminates separated by said non-magnetic metallic layers is preferably three or more.

Preferable examples and embodiments are defined in the dependent claims as well as hereinafter referred to.

Preferably, each of the first and second magnetic thin layers includes main components of a structure given by:

$$(Ni_X Co_{1-X})_{X'} Fe_{1-X'} \qquad (1)$$

where X and X' indicate atomic composition ratios in the range of:

$$0.6 \leq X \leq 1.0 \quad \text{and} \quad 0.7 \leq X' \leq 1.0 \tag{2}.$$

Alternatively, each of the first and second magnetic thin layers includes main components of a structure given by:

$$(Co_Y Ni_{1-Y})_Z Fe_{1-Z} \tag{3}$$

where Y and Z indicate atomic composition ratios in the range of:

$$0.4 \leq Y \leq 1.0 \quad \text{and} \quad 0.8 \leq Z \leq 1.0 \tag{4}.$$

Also alternatively, when the first magnetic thin layer includes the main components of the structure (1), the second magnetic thin layer may include the main components of the structure (3). Conversely, when the first magnetic thin layer includes the main components of the structure (3), the second magnetic thin layer may include the main components of the structure (1).

Advantageously, each of the nonmagnetic metallic thin layer and the nonmagnetic metallic layer is made of one of copper, silver, and gold. Of these elements, copper is most preferable. Also, the use of a conductive metallic film made of, for example, iron-manganese for the antiferromagnetic layer is preferred.

Each of the first and second magnetic thin layers is made of a magnetic material having a low magnetostriction satisfying the range indicated by one of the formulas (2) and (4) stated above. These layers may be Ni-Fe or Ni-Co based binary magnetic thin layers instead of the ternary magnetic thin layers mentioned above.

In practice, the so-called patterning technique is generally employed in making the element according to the present invention to allow electric current to flow through the multi-laminated structure in a direction perpendicular to layer surfaces, thereby providing a large output.

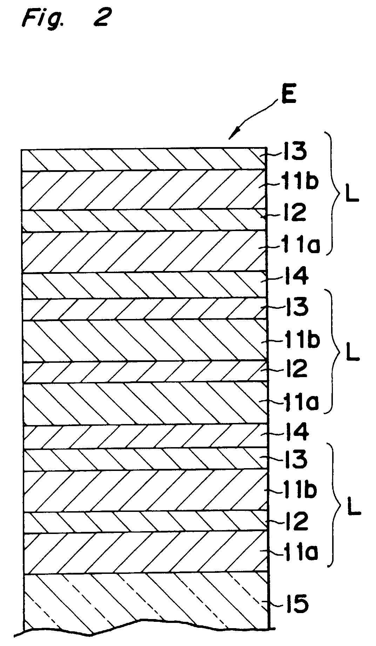

Referring to Fig. 2 depicting one preferred embodiment of the present invention, each second magnetic thin layer 11b shows unidirectional anisotropy by magnetically coupling with the associated antiferromagnetic layer 13, thereby restraining the rotation of spin in a certain direction. On the other hand, each first magnetic thin layer 11a is separated from the associated second magnetic thin layer 11b by a nonmagnetic metallic thin layer 12 interposed therebetween. Accordingly, when a vary small magnetic field is applied to the magnetoresistive element, the spin of the first magnetic thin layer 11a rotates in the direction of the applied magnetic field, whereas the rotation of the spin of the second magnetic thin layer 11b is restrained by the magnetic coupling with the antiferromagnetic layer 13. As a result, both the magnetic layers 11a and 11b have an antiparallel spin configuration and, hence, the magnetic resistance of the magnetoresistive element becomes large. When the magnitude of the magnetic field becomes large to some extent, the magnetizations of the two layers 11a and 11b become parallel, thus reducing the resistance. In the fashion noted above, the magnetic resistance varies.

Although a huge MR ratio cannot be obtained by a single multi-layered structure of 11a/12/11b/13, the magnetoresistive element having a large MR ratio and operable in a very small magnetic field can be obtained by a multi-laminated structure in which a plurality of laminates each of the 11a/12/11b/13 structure are deposited one above the other with a nonmagnetic metallic layer 14 interposed between neighboring laminates to weaken the magnetic coupling between the neighboring laminates.

It can be determined from an MR curve of the magnetoresistive element whether or not the magnetic coupling between the neighboring laminates has been weakened by the nonmagnetic metallic layer 14. If such magnetic coupling has been weakened, the direction of magnetization of the first magnetic thin layer 11a not in contact with the antiferromagnetic layer 13 is reversed by applying a very small magnetic field, thus providing a giant MR effect. If the magnetic coupling between the neighboring laminates has not been weakened, no reversal in the direction of magnetization of the first magnetic thin layer 11a occurs in the very small magnetic field and, hence, no giant MR effect can be obtained.

As described hereinabove, the element according to the present invention exhibits a very large magnetoresistive effect in a very small magnetic field at room temperature by taking full advantage of properties of artificial metallic superlattices. Accordingly, this element is suited for use in a highly sensitive MR head.

## BRIEF DESCRIPTION OF THE DRAWINGS

The above and other objectives and features of the present invention will become more apparent from the following description of preferred embodiments thereof with reference to the accompanying drawings, throughout which like parts are designated by like reference numerals, and wherein:

Fig. 1 is a schematic vertical sectional view of a conventional element having magnetoresistive effect, known as the "spin-valve" type element;

Fig. 2 is a schematic vertical sectional view of an element having magnetoresistive effect according to the present invention; and

Fig. 3 is a schematic vertical sectional view of a modification of the element of Fig. 2, in which electric current flows in a direction perpendicular to the direction in which individual layers extend.

## DETAILED DESCRIPTION OF THE PREFERRED EMBODIMENTS

Referring now to the drawings, there is schematically shown in Fig. 2 an element E having magnetoresistive effect according to the present invention.

As shown in Fig. 2, the element E has a multi-laminated structure deposited on a substrate 15. The multi-laminated structure includes a plurality of, for example three, laminates L each including a first magnetic thin layer 11a, a nonmagnetic metallic thin layer 12, a second magnetic thin layer 11b, and an antiferromagnetic layer 13 deposited one above the other in this order. A nonmagnetic metallic layer 14 is interposed between neighboring laminates L to weaken a magnetic coupling therebetween.

A conductive metallic film made of Fe-Mn or the like is preferably used for the antiferromagnetic layer 13.

Each of the first and second magnetic thin layers 11a and 11b includes main components of a structure given by:

$$(Ni_X Co_{1-X})_{X'} Fe_{1-X'} \qquad (1)$$

where X and X' indicate atomic composition ratios in the range of:

$$0.6 \leq X \leq 1.0 \qquad \text{and} \qquad 0.7 \leq X' \leq 1.0 \qquad (2).$$

Alternatively, each of the first and second magnetic thin layers 11a and 11b includes main components of a structure given by:

$$(Co_Y Ni_{1-Y})_Z Fe_{1-Z} \qquad (3)$$

where Y and Z indicate atomic composition ratios in the range of:

$$0.4 \leq Y \leq 1.0 \qquad \text{and} \qquad 0.8 \leq Z \leq 1.0 \qquad (4).$$

Each of the nonmagnetic metallic thin layer 12 and the nonmagnetic metallic layer 14 is made of one of Cu, Ag, and Au. Of these elements, Cu is particularly favorable.

The first and second magnetic thin layers 11a and 11b may have different structures given by (1) and (3), respectively, or those given by (3) and (1), respectively.

Ni-rich alloys of the structure (1) containing Ni, Co and/or Fe have a low magnetostriction and indicate a soft magnetism when the composition ratio thereof satisfies the formula (2). Representative alloys include $Ni_{0.8}Co_{0.1}Fe_{0.1}$, $Ni_{0.8}Fe_{0.2}$, $Ni_{0.8}Co_{0.2}$ and the like. The composition (1) may be added with Nb, Mo, Cr, W or Ru in order to improve the soft magnetism, abrasion resistance, and corrosion resistance of the alloys.

Co-rich alloys of the structure (3) containing Co, Ni and/or Fe have also a low magnetostriction when the composition ratio thereof satisfies the formula (4). $Co_{0.9}Fe_{0.1}$ is representative of such alloys.

In general, magnetoresistive elements are used with a total thickness of hundreds of angstroms. For this reason and for the practice of the present invention, it is necessary to form each of the first and second magnetic thin layers 11a and 11b so as to have a thickness less than 100Å. However, when the thickness of such layers is less than 5Å, magnetization thereof is deteriorated at room temperature due to the drop of Curie temperature, though the degree of deterioration differs depending on the composition thereof. In order to allow the MR ratio of the magnetoresistive element according to the present invention to be much greater than that of the conventional ones, it is preferred that the thickness of each magnetic thin layer 11a and 11b is in the range of 20 to 40Å.

The first and second magnetic thin layers 11a and 11b are required to have a low magnetostriction. This is because the magnetoresistive element is required to operate in a weak magnetic field and the use thereof for an MR head causes noises when the magnetostriction of the first and second magnetic thin layers 11a and 11b is high. A film made of an Ni-rich alloy of the structure given by the formulas (1) and (2) or a film made of a Co-rich alloy of the structure given by the formulas (3) and (4) has a low magnetostriction. Accordingly, one of them can be used for the first and second magnetic thin layers 11a and 11b, or both of them can be used simultaneously for the first and second magnetic thin layers 11a and 11b.

The metallic thin layer 12 interposed between the first and second magnetic thin film layers 11a and 11b of the above-described structures is required to be nonmagnetic and, in addition, not to appreciably react with the two magnetic thin layers 11a and 11b in the interfaces between it and the magnetic thin layers 11a and 11b. Preferably, Cu, Ag, Au or the like is used for the nonmagnetic metallic thin layer 12. Of these elements, the use of Cu is preferred for enhanced MR properties. If the thickness of the nonmagnetic metallic thin layer 12 exceeds 100Å, the MR ratio of the magnetoresistive element is reduced. On the other hand, if no nonmagnetic metallic thin layer is interposed between the first and second magnetic thin layers 11a and 11b or if the thickness of the nonmagnetic metallic thin layer 12 is less than 5Å, the first and second magnetic thin layers 11a and 11b are ferromagnetically coupled with each other. As a result, a giant magnetoresistive effect cannot be obtained. In order for the magnetoresistive element according to the present invention to be much superior in MR properties to the conventional ones, it is preferable that the thickness of the nonmagnetic metallic thin layer 12 ranges from 5 to 30Å.

The nonmagnetic metallic layer 14, intended to provide magnetic insulation between the antiferromagnetic layer 13 and the neighboring laminate L, can weaken a magnetic coupling therebetween if this layer 14 has a thickness larger than 5Å. This value, however, varies according to the flatness of the nonmagnetic metallic layer 14. As is the case with the nonmagnetic metallic thin layer 12, the nonmagnetic metallic layer 14 requires a thickness less than 100Å and, preferably, a thickness of 5 to 30Å from the viewpoint of the MR properties.

For the same reasons as above, the antiferromagnetic layer 13 requires a thickness less than 100Å. In order for the antiferromagnetic layer 13 to magnetically couple with the second magnetic thin layer 11b to thereby provide sufficient unidirectional anisotropy, the antiferromagnetic layer 13 generally requires a thickness greater than 10Å. From the viewpoint of the MR properties, the thickness of 10 to 60Å is preferred.

The effect of the magnetoresistive element according to the present invention is described below by way of embodiments.

## Embodiment 1

A magnetoresistive element having the construction discussed below was formed on a glass substrate using a multi-target sputtering system. This sputtering system comprises a sputtering chamber, a rotatable substrate holder, a plurality of material sources called "targets", and a shutter interposed between the substrate holder and the targets.

A laminate A' of an Ni-Co-Fe(30Å)/Cu(20Å)/Co-Fe(30Å)/Fe-Mn(50Å) structure was initially deposited on the substrate. Parenthesized numerical values denote the thicknesses of associated layers. The targets for the first magnetic layer 11a, nonmagnetic metallic layer 12, second magnetic layer 11b, and antiferromagnetic layer 13 had a diameter of 80 mm and were made up of $Ni_{0.8}Co_{0.1}Fe_{0.1}$, Cu, $Co_{0.9}Fe_{0.1}$, and $Fe_{50}Mn_{50}$, respectively. The thickness of each layer was controlled by opening and closing the shutter. Upon measurement of the MR properties of the laminate A' at room temperature in a magnetic field of 100 Oe, it was found that the MR ratio was 2% and the width of the magnetic field allowing the MR ratio to change was 5 Oe.

Five laminates A' were deposited one above the other to form a multi-laminated structure A''. In this application, this structure A'' is represented by $[A']^5$. The MR ratio of the structure A'' was less than 1%.

In order to weaken the magnetic coupling between neighboring laminates A', a Cu layer was inserted between the neighboring laminates A' to thereby form a multi-laminated structure A:$[A'/Cu(30Å)]^5$. The MR ratio of this structure A thus formed was 10% and the width of the magnetic field allowing the MR ratio to change was 3 Oe.

When the thickness of the Cu layer was set to 50Å and 100Å, the MR ratio was reduced to 5% and 3%, respectively. When the thickness of each of the first and second magnetic layers 11a and 11b was set to 10Å and 50Å, the MR ratio was reduced to 4% and 5%, respectively. When the thickness of the antiferromagnetic layer 13 was set to 70Å, the MR ratio was reduced to 5%.

## Embodiment 2

A $[\{Ni-Co-Fe(20Å)/Cu(20Å)/Ni-Co-Fe(20Å)/Fe-Mn(50Å)\}/Cu(40Å)]^3$ structure B was prepared using targets having a diameter of 80 mm and made up of $Ni_{0.8}Co_{0.05}Fe_{0.15}$, Cu, $Fe_{50}Mn_{50}$, and Cu for the first and second magnetic layers 11a and 11b, nonmagnetic metallic layer 12, antiferromagnetic layer 13, and nonmagnetic metallic layer 14, respectively. Similarly, a $[\{Ni-Co(40Å)/Cu(20Å)/Ni-Co(40Å)/Fe-Mn(50Å)\}/Cu(20Å)]^4$ structure C was prepared using targets having a diameter of 80 mm and made up of $Ni_{0.8}Co_{0.2}$, Cu, $Fe_{50}Mn_{50}$, and Cu for the first and second magnetic layers 11a and 11b, nonmagnetic metallic layer 12, antiferromagnetic layer 13, and nonmagnetic metallic layer 14, respectively.

The MR ratios of the structures B and C thus formed were 6% and 8%, respectively, while the widths of the magnetic field required to cause MR changes of the structures B and C were 2 Oe and 10 Oe, respectively.

Embodiment 3

A $[\{Ni\text{-}Fe\text{-}Co(20Å)/Cu(10Å)/Co\text{-}Fe(20Å)/Fe\text{-}Mn(50Å)\}/Cu(10Å)]^N$ structure D was prepared using targets having a diameter of 80 mm and made up of $Ni_{0.8}Fe_{0.15}Co_{0.05}$, Cu, $Co_{0.9}Fe_{0.1}$, $Fe_{50}Mn_{50}$, and Cu for the first magnetic layer 11a, nonmagnetic metallic layer 12, second magnetic layer 11b, antiferromagnetic layer 13, and nonmagnetic metallic layer 14, respectively.

The dependency of the MR properties on the number (N) of laminates was examined. The result is shown below in Table 1.

Table 1

| Number of laminates: N | 1 | 2 | 3 | 5 | 10 |
|---|---|---|---|---|---|
| MR (%) | 0.5 | 2 | 6 | 10 | 11 |

Table 1 indicates that the preferred number of laminates is three or more.

Embodiment 4

Fig. 3 depicts an element having magnetoresistive effect which was prepared as follows.

An Au-Cr terminal 21 was initially attached to a substrate 26. Then, five laminates 24 each of a $[\{Ni\text{-}Co\text{-}Fe(30Å)/Cu(20Å)/Co\text{-}Fe(30Å)/Fe\text{-}Mn(50Å)\}/Cu(30Å)]$ structure were deposited one above the other to form an element portion somewhat analogous to the element shown in Fig. 2. This element portion was then divided into two elements 25 by the use of the so-called patterning technique, and two terminals 22 and 23 were attached to the associated top surfaces of the two elements 25, respectively, to form an element assembly having magnetoresistive effect in which electric current flows in a direction perpendicular to the layer surfaces.

The MR ratio of this element assembly was found 20% and the width of the magnetic field required to cause changes in MR ratio was found 30 Oe.

**Claims**

1. An element (E) having magnetoresistive effect comprising:

   a first magnetic thin layer (11a);
   a nonmagnetic metallic thin layer (12) deposited on said first magnetic thin layer (11a);
   a second magnetic thin layer (11b) deposited on said nonmagnetic metallic thin layer (12); and
   an antiferromagnetic layer (13) deposited on said second magnetic thin layer (11b);

   characterized by

   a plurality of laminates (L) of said layers (11a, 12, 11b, 13) deposited one above the other; and
   a plurality of nonmagnetic metallic layers (14) each having a thickness of 0.5 to 3 nm and being interposed between neighboring laminates (L) to weaken a magnetic coupling between the neighboring laminates (L); and
   said first magnetic thin layer (11a) having a low magnetostriction and a thickness of 2 to 4 nm;
   said nonmagnetic metallic thin layer (12) having a thickness of 0.5 to 3 nm;
   said second magnetic thin layer (11b) having a low magnetostriction and a thickness of 2 to 4 nm; and
   said antiferromagnetic layer (13) having a thickness of 1 to 6 nm.

2. The element (E) according to claim 1, wherein the number of said laminates (L) separated by said nonmagnetic metallic layers (14) is three or more.

3. The element according to claim 1 or 2, wherein each of said first and second magnetic thin layers (11a) and (11b) includes main components of a structure given by:

$$(Ni_XCo_{1-X})_{X'}Fe_{1-X'}$$

where X and X' indicate atomic composition ratios in the range of:

$$0.6 \leq X \leq 1.0 \quad \text{and} \quad 0.7 \leq X' \leq 1.0.$$

4. The element according to claim 1 or 2, wherein each of said first and second magnetic thin layers (11a) and (11b) includes main components of a structure given by:

$$(Co_YNi_{1-Y})_ZFe_{1-Z}$$

where Y and Z indicate atomic composition ratios in the range of:

$$0.4 \leq Y \leq 1.0 \quad \text{and} \quad 0.8 \leq Z \leq 1.0.$$

5. The element according to claim 1 or 2, wherein said first and second magnetic thin layers (11a) and (11b) include respective main components of structures given by:

$$(Ni_XCo_{1-X})_{X'}Fe_{1-X'} \quad \text{and} \quad (Co_YNi_{1-Y})_ZFe_{1-Z'}$$

respectively, where X, X', Y, and Z indicate atomic composition ratios in the range of:

$$0.6 \leq X \leq 1.0, \quad 0.7 \leq X' \leq 1.0, \quad 0.4 \leq Y \leq 1.0 \quad \text{and} \quad 0.8 \leq Z \leq 1.0.$$

6. The element according to claim 1 or 2, wherein said first and second magnetic thin layers (11a) and (11b) include respective main components of structures given by:

$$(Co_YNi_{1-Y})_ZFe_{1-Z} \quad \text{and} \quad (Ni_XCo_{1-X})_{X'}Fe_{1-X''}$$

respectively, where X, X', Y, and Z indicate atomic composition ratios in the range of:

$$0.6 \leq X \leq 1.0, \quad 0.7 \leq X' \leq 1.0, \quad 0.4 \leq Y \leq 1.0 \quad \text{and} \quad 0.8 \leq Z \leq 1.0.$$

7. The element according to claim 1 or 2, wherein each of said nonmagnetic metallic thin layer (12) and said nonmagnetic metallic layer (14) is made of one of copper, silver, and gold.

8. The element according to claim 1 or 2, wherein each of said nonmagnetic metallic thin layer (12) and said nonmagnetic metallic layer (14) is made of copper.

9. The element according to claim 1 or 2, wherein said antiferromagnetic layer (13) is made of an iron-manganese alloy film.

10. The element according to any preceding claim, further comprising terminals (21, 22 or 23) each attached to an outermost one of the plurality of laminates (L) so that electric current flows in a direction perpendicular to layer surfaces.

**Patentansprüche**

1. Ein Element (E) mit magnetoresistiven Eigenschaften mit:

einer ersten magnetischen Dünnschicht (11a);
einer auf der ersten magnetischen Dünnschicht (11a) aufgebrachten nicht magnetischen, metallenen Dünnschicht (12);
einer auf der nicht magnetischen, metallenen Dünnschicht (12) aufgebrachten zweiten magnetischen Dünnschicht (11b); und
einer auf der zweiten magnetischen Dünnschicht (11b) aufgebrachten antiferromagnetischen Schicht (13),

gekennzeichnet durch

eine Mehrzahl von Laminaten (L) der übereinander angeordneten Schichten (11a, 12, 11b, 13) und
eine Mehrzahl von nicht magnetischen Metallschichten (14), von denen jede eine Dicke von 0,5 bis 3 nm aufweist und zwischen benachbarten Laminaten (L) angeordnet ist, um eine magnetische Kopplung zwischen den benachbarten Laminaten (L) abzuschwächen, und
welche erste magnetische Dünnschicht (11a) eine geringe Magnetostriktion und eine Dicke von 2 bis 4 nm aufweist;
welche nicht magnetische, metallene Dünnschicht (12) eine Dicke von 0,5 bis 3 nm aufweist;
welche zweite magnetische Dünnschicht (11b) eine geringe Magnetostriktion und eine Dicke von 2 bis 4 nm aufweist und
welche antiferromagnetische Schicht (13) eine Dicke von 1 bis 6 nm aufweist.

2. Das Element (E) nach Anspruch 1, bei dem die Anzahl der durch nicht magnetische Metallschichten (14) getrennten Laminate (L) drei oder mehr beträgt.

3. Das Element nach Anspruch 1 oder 2, bei dem jede der ersten und zweiten magnetischen Dünnschichten (11a, 11b) Haupbestandteile enthält, deren Aufbau

$$(Ni_X Co_{1-X})_{X'} Fe_{1-X'}$$

entspricht, wobei X und X' Atomkompositionsverhältnisse im Bereich von

$$0,6 \leq X \leq 1,0 \quad \text{und} \quad 0,7 \leq X' \leq 1,0$$

angeben.

4. Das Element nach Anspruch 1 oder 2, bei dem jede der ersten und zweiten magnetischen Dünnschichten (11a, 11b) Hauptbestandteile enthält, deren Aufbau

$$(Co_Y Ni_{1-Y})_Z Fe_{1-Z}$$

entspricht, wobei Y und Z Atomkompositionsverhältnisse im Bereich von

$$0,4 \leq Y \leq 1,0 \quad \text{und} \quad 0,8 \leq Z \leq 1,0$$

angeben.

5. Das Element nach Anspruch 1 oder 2, bei dem die erste und zweite magnetische Dünnschicht (11a, 11b) jeweils Hauptbestandteile enthält, deren Aufbau

$$(Ni_X Co_{1-X})_{X'} Fe_{1-X'} \text{ bzw. } (Co_Y Ni_{1-Y})_Z Fe_{1-Z}$$

entsprechen, wobei X, X', Y und Z Atomkompositionsverhältnisse angeben, die im Bereich von

$$0{,}6 \leq X \leq 1{,}0, \qquad 0{,}7 \leq X' \leq 1{,}0, \qquad 0{,}4 \leq Y \leq 1{,}0 \qquad \text{und} \qquad 0{,}8 \leq Z \leq 1{,}0$$

liegen.

**6.** Das Element nach Anspruch 1 oder 2, bei dem die erste und zweite magnetische Dünnschicht (11a, 11b) jeweils Hauptbestandteile enthält, deren Aufbau

$$(Co_Y Ni_{1-Y})_Z Fe_{1-Z} \text{ bzw. } (Ni_X Co_{1-X})_{X'} Fe_{1-X'}$$

entsprechen, wobei X, X', Y und Z Atomkompositionsverhältnisse angeben, die im Bereich von

$$0{,}6 \leq X \leq 1{,}0, \qquad 0{,}7 \leq X' \leq 1{,}0, \qquad 0{,}4 \leq Y \leq 1{,}0 \qquad \text{und} \qquad 0{,}8 \leq Z \leq 1{,}0$$

liegen.

**7.** Das Element nach Anspruch 1 oder 2, bei dem die nicht magnetische, metallene Dünnschicht (12) und die nicht magnetische Metallschicht (14) aus einem der Metalle Kupfer, Silber oder Gold gefertigt sind.

**8.** Das Element nach Anspruch 1 oder 2, bei dem jede nicht magnetische metallene Dünnschicht (12) sowie die nicht magnetische Metallschicht (14) aus Kupfer gefertigt ist.

**9.** Das Element nach Anspruch 1 oder 2, bei dem die antiferromagnetische Schicht (13) aus einem Film einer Eisenmanganlegierung besteht.

**10.** Das Element nach einem der vorhergehenden Ansprüche mit Anschlüssen (21, 22 oder 23), die an einem äußeren der Mehrzahl von Laminaten (L) so angebracht ist, daß elektrischer Strom senkrecht zur Schichtoberfläche fließt.

**Revendications**

**1.** Elément (E) présentant un effet magnétorésistif comprenant :

   une première couche mince magnétique (11a) ;
   une couche mince métallique non magnétique (12) déposée sur ladite première couche mince magnétique (11a) ;
   une seconde couche mince magnétique (11b) déposée sur ladite couche mince métallique non magnétique (12) ; et
   une couche anti-ferromagnétique (13) déposée sur ladite seconde couche mince magnétique (11b) ;

   caractérisé par

   une pluralité de stratifiés (L) desdites couches (11a, 12, 11b, 13) déposées les uns au-dessus des autres ; et
   une pluralité de couches métalliques non magnétiques (14) ayant chacune une épaisseur située entre 0,5 à 3 nm et étant interposées entre les stratifiés voisins (L) pour affaiblir le couplage magnétique entre les stratifiés voisins (L) ; et
   ladite première couche mince magnétique (11a) ayant une faible magnétostriction et une épaisseur située entre 2 et 4 nm.
   ladite couche mince métallique non magnétique (12) ayant une épaisseur située entre 0,5 et 3 nm ;
   ladite seconde couche mince magnétique (11b) ayant une faible magnétostriction et une épaisseur située entre 2 et 4 nm ; et
   ladite couche anti-ferromagnétique (13) ayant une épaisseur située entre 1 et 6 nm.

**2.** Elément (E) selon la revendication 1, dans lequel le nombre desdits stratifiés (L) séparés par lesdites couches métalliques non magnétiques (14) est de trois ou plus.

3. Elément selon la revendication 1 ou 2, dans lequel chacune desdites première et seconde couches minces magnétiques (11a) et (11b) comprend les composants principaux de la structure donnée par :

$$(Ni_XCo_{1-X})_{X'}Fe_{1-X'}$$

dans laquelle X et X' indiquent les rapports de composition atomique dans la plage de :

$$0,6 \leq X \leq 1,0 \quad \text{et} \quad 0,7 \leq X' \leq 1,0.$$

4. Elément selon la revendication 1 ou 2, dans lequel chacune desdites première et seconde couches minces magnétiques (11a) et (11b) comprend des composants principaux d'une structure donnée par :

$$(Co_YNi_{1-Y})_ZFe_{1-Z}$$

dans laquelle Y et Z indiquent les rapports de composition atomique dans la plage de :

$$0,4 \leq Y \leq 1,0 \quad \text{et} \quad 0,8 \leq Z \leq 1,0$$

5. Elément selon la revendication 1 ou 2, dans lequel lesdites première et seconde couches minces magnétiques (11a) et (11b) comprennent des composants principaux d'une structure donnée par :

$$(Ni_XCo_{1-X})_{X'}Fe_{1-X'} \quad \text{et} \quad (Co_YNi_{1-Y})_ZFe_{1-Z'}$$

respectivement, dans lesquelles X, Y', Y et Z indiquent les rapports de composition atomique dans la plage de :

$$0,6 \leq X \leq 1,0, \quad 0,7 \leq X' \leq 1,0, \quad 0,4 \leq Y \leq 1,0 \quad \text{et} \quad 0,8 \leq Z \leq 1,0.$$

6. Elément selon la revendication 1 ou 2, dans lequel lesdites première et seconde couches minces magnétiques (11a) et (11b) comprennent des composants principaux respectifs d'une structure donnée par :

$$(Co_YNi_{1-Y})_ZFe_{1-Z} \quad \text{et} \quad (Ni_XCo_{1-X})_{X'}Fe_{1-X''}$$

respectivement, dans lesquelles X, X', Y et Z indiquent les rapports de composition atomique dans la plage de :

$$0,6 \leq X \leq 1,0, \quad 0,7 \leq X' \leq 1,0, \quad 0,4 \leq Y \leq 1,0 \quad \text{et} \quad 0,8 \leq Z \leq 1,0.$$

7. Elément selon la revendication 1 ou 2, dans lequel chacune desdites couches minces métalliques non magnétiques (12) et ladite couche métallique non magnétique (14) sont constituées d'un élément parmi le cuivre, l'argent et l'or.

8. Elément selon la revendication 1 ou 2, dans lequel chaque couche desdites couches minces métalliques non magnétiques (12) et ladite couche métallique non magnétique (14) sont constituées de cuivre.

9. Elément selon la revendication 1 ou 2, dans lequel ladite couche anti-ferromagnétique (13) est constituée d'un film d'alliage de fer-manganèse.

10. Elément selon l'une quelconque des revendications précédentes, comprenant de plus des bornes (21, 22 ou 23) chacune fixée à un stratifié le plus à l'extérieur de la pluralité de stratifiés (L) de sorte que le courant électrique circule dans une direction perpendiculaire aux surfaces des couches.

Fig. 1 PRIOR ART

1

2

3

2

4

Fig. 3

22

23

25

25

24

26

21

*Fig.* **2**